# EUROPEAN PATENT APPLICATION

(11) **EP 0 933 875 A1**
(43) Date of publication of application: **04.08.1999**
(21) Application number: 98101753.6
(22) Date of filing: 02.02.1998
(51) Int. Cl.: H03L 1/02

(54) **Voltage controlled oscillator**

(71) Applicant: Sony International (Europe) GmbH, 50829 Köln (DE)
(72) Inventor: Ito, Koichi, Heisenbergbogen 1, 85609 Aschheim (DE)
(74) Representative: Körber, Martin, Dipl.-Phys.

(57) **Abstract**

The present invention relates to a voltage controlled oscillator, comprising a resonance circuit (1, 31) to provide an oscillation signal, a tuning circuit (2, 32) which is connected to the resonance circuit (1, 31) and determines the frequency of the oscillation signal, whereby the tuning circuit (2, 32) includes electrically controlled adjustment means (13, 47) to tune the frequency of the oscillation signal, and a temperature detection means (3, 33) for temperature compensation of the frequency of the oscillation signal. The voltage controlled oscillator of the present invention provides an accurate and stable oscillation signal even in varying temperature conditions.

## Description

The present invention relates to a voltage controlled oscillator, comprising a resonance circuit to provide an oscillation signal and a tuning circuit, which is connected to the resonance circuit and determines the frequency of the oscillation signal, whereby the tuning circuit includes electrically controlled adjustment means to tune the frequency of the oscillation signal.

Such a voltage controlled oscillator is known in the state of the art, for example from JP-A-09116429. The tuning tuning thereby has variable capacitance diode whose capacitance varies with an input signal. A first DC component cutting capacitor is connected to the variable capacitance diode. An inductor is connected between the connection node of the first DC component cutting capacitor and the ground. A second DC component cutting capacitor is connected between the node of a frequency adjustment variable capacitance diode and the connection node of the DC component cutting capacitor. The frequency adjustment variable capacitance diode is supplied with a frequency adjustment control voltage through an electrically controlled adjustment means, for example a variable resistor, included in the tuning circuit. Although the voltage controlled oscillator disclosed in the above-identified application eliminates the influence of mechanical distortion for exarnple from a trimmer capacitor, it suffers from severe disadvantages. If this known voltage controlled oscillator is for example used in a portable telephone, it has to operate accurately in a wide temperature range. Since most of the elements used in a voltage controlled oscillator have temperature dependent properties, an accurate frequency of the oscillation signal cannot be obtained in varying temperature conditions.

The object of the present invention is therefore to provide a voltage controlled oscillator, comprising a resonance circuit to provide an oscillation signal and a tuning circuit, which is connected to the resonance circuit and determines the frequency of the oscillation signal, whereby the tuning circuit includes electrically controlled adjustment means to tune the frequency of the oscillation signal, which assures an accurate frequency of the oscillation signal even in varying temperature conditions.

The subject is achieved by a voltage controlled oscillator according to the preamble of claim 1, which is characterized by a temperature detection means for temperature compensation of the frequency of the oscillation signal.

Advantageous features of the present invention are defined in the corresponding subclaims.

The voltage controlled oscillator according to the present invention assures an improved frequency accuracy of the oscillation signal output by the oscillator and therefore established an improved operation of the oscillator even in varying conditions. The temperature detection means detects the temperature of the voltage controlled oscillator and/or the temperature of the place, in which the voltage controlled oscillator is used, and enables a temperature compensation of the frequency of the oscillation signal. Thereby the variation of the resonance frequency of the resonance circuit of the voltage controlled oscillator caused by a temperature variation is corrected.

Thus, the voltage controlled oscillator according to the present invention can advantageously be used in devices which are operated in varying temperature conditions, for example in a portable telephone.

Advantageously, the temperature detection means supplies a temperature detection signal to the tuning circuit for temperature compensation of the frequency of the oscillation signal. Thereby, the adjustment means is controlled on the basis of the temperature detection signal. In this case, the adjustment means can be controlled by a control means, which temperature compensates the tuning of the frequency of the oscillation signal on the basis of the temperature detection signal. The control means can thereby read temperature compensation information corresponding to the received temperature detection signal from a memory means for the temperature compensation.

Advantageously, the temperature detection circuit comprises a thermal resistor. Further advantageously, the temperature detection means and the resonance circuit are operated by the same operating voltage.

Advantageous embodiments of the present invention are explained in detail in the following description relating to the drawings, in which
fig. 1 shows a first embodiment of a voltage controlled oscillator according to the present invention, and
fig. 2 shows a second embodiment of a voltage controlled oscillator according to the present invention.

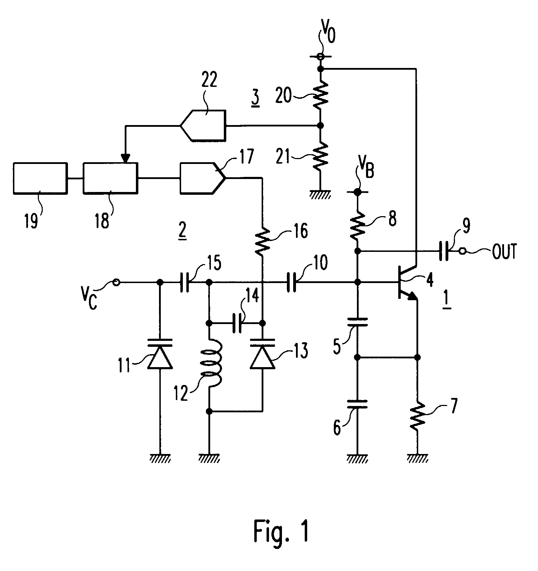

In fig. 1 the voltage controlled oscillator of the first embodiment of the present invention is shown. The voltage controlled oscillator of the first embodiment outputs the oscillation signal at a single output terminal, whereas the voltage controlled oscillator of the second embodiment outputs the output signal differentially at two separate output terminals. The voltage controlled oscillator of the first embodiment comprises a resonance circuit 1, a tuning circuit 2 and a temperature detection circuit 3. The temperature detection circuit 3 and the resonance circuit 1 are fed by the same operating voltage V_{O} at a common operating voltage terminal. The tuning circuit 2 is operated by a control voltage V_{C}. The tuning circuit 2 is basically a resonating circuit which resonates with its resonance frequency. The resonance frequency is then taken up by the resonance circuit 1 which oscillates with this resonance frequency and amplifies it. The oscillation signal generated in the resonance circuit 1 is output at an output terminal OUT of the resonance circuit 1.

The resonance circuit 1 comprises a transistor 4, which is provided with a common-emitter connection. The operating voltage V_{O} is supplied to the collector of the transistor 4. The emitter of the transistor 4 is connected to a grounded resistor 7.

The base of the transistor 4 is connected with two capacitors 5 and 6, which are arranged in series, whereby the emitter of the transistor 4 is connected with an intermediate point of resistor 5 and resistor 6. The resistor 6 is grounded. Thus, the two capacitors 5 and 6 represent a voltage divider and the voltage controlled oscillator of the first embodiment of the present invention bases on the classic Colpitts oscillator circuit.

The base of the transistor 4 is via a resistor 8 biased by a bias voltage V_{B}. Further, the base of the transistor 4 is connected to a capacitor 9 leading to the output terminal OUT, at which the oscillation signal is provided. The capacitor 9 serves for cutting off DC components.

The tuning circuit 2 is connected via a capacitor 10 to the resonance circuit 1. In particular, the capacitor 10 is connected to the base of the transistor 4. Thereby, the capacitor 10 cuts off DC components.

The tuning circuit 2 is operated by a control voltage V_{C}, which is a DC voltage and is connected to and defines the capitance of a variable capacitance diode 11, which is grounded. The variable capacitance diode 11 is via a capacitor 15 connected to an inductor 12. The inductor 12 can thereby be a discrete component, but also a dielectric pole or a strip line. The inductor 12 is grounded and arranged parallel to the diode 11. The resonance frequency of the tuning circuit depends on the inductance of the inductor 12 and the total capacitance of the capacitors. The voltage level of the control voltage Vc tunes the capacitance of the diode 11 and thus the resonance frequency of the tuning circuit and therefore the resonance circuit 1.

Usually, capacitors have a deviation, thus the resonance frequency is not the ideal center frequency, even if the control voltage V_{C} is set to the center voltage. Therefore, the tuning circuit 2 further comprises an electrically controlled adjustment means in form of another variable capacitance diode 13 to tune the inductor 12 and therefore to tune the resonance frequency of the resonance circuit 1 accurately to the required value. The variable capacitance diode 13 is connected in parallel to the inductor 12 and also grounded. The variable capacitance diode 13 is tuned by an adjustment voltage coming from a D/A-converter 17 via a resistor 16. A capacitance 14 is connected between the inductor 12 and the variable capacitance diode 13 to cut off DC components.

The adjustment voltage output by the D/A-converter 17 is set by a control means 18, which can for example be a central processing unit. The control means 18 reads information from a memory 19 and controls the tuning of the variable capacitance diode 13 and thus the fine tuning of the resonance frequency of the resonance circuit 1 exactly to the center frequency of the respective frequency band. The control means 18 can thereby control the D/A-converter 17 to supply two or more alternative adjustment voltages, so that the resonance circuit can be tuned to two or more alternative center frequencies. In this case the voltage controlled oscillator is band switchable.

The temperature detection circuit 3 comprises in the case shown in fig. 1 a thermal resistor 21, which is grounded. The thermal resistor 21 is supplied by the operating voltage V_{O} via a resistor 20. The operating voltage V_{O} is the same as for the resonance circuit 1. An A/D-converter 22 taps a temperature information in form of a temperature dependent voltage between the resistor 20 and the thermoresistor 21. The temperature information is converted in the A/D-converter into digital data and supplied to the control means 18.

In the memory 19, temperature compensation information, for example a temperature matrix table, is recorded. The temperature compensation information has been measured and/or calculated during or after the manufacturing of the voltage controlled oscillator and allows for a correct temperature compensation of the resonance frequency for each temperature value detected in the temperature detection circuit 3. When a certain temperature is detected by the temperature detection circuit 3 and supplied via the A/D-converter 22 to the control unit 18, the control unit 18 reads a temperature compensation information corresponding to the detected temperature from the memory 19 and provides for a fine tuning of the resonance circuit to the center frequency by means of a corresponding adjustment voltage supplied to the variable capacitance diode 13 via the D/A-converter 17. Thus, a temperature compensation of the resonance frequency can be performed automatically for each detected temperature and an accurate setting of the voltage controlled oscillator to the required resonance frequency is performed in all temperature conditions.

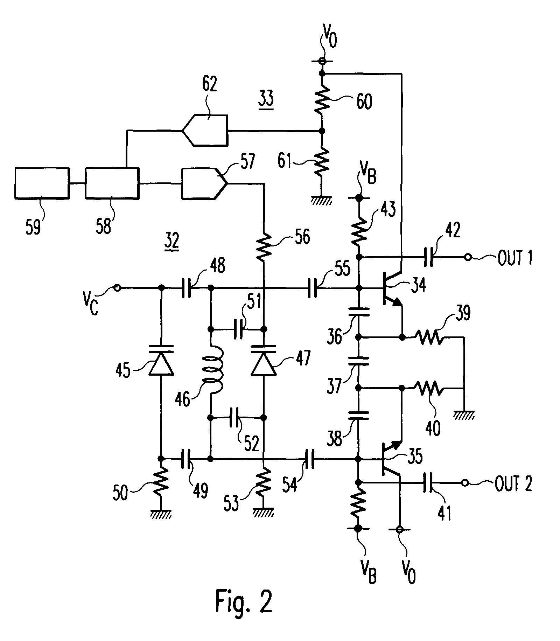

A second embodiment of the voltage controlled oscillator of the present invention is shown in fig. 2. The voltage controlled oscillator of the second embodiment provides a differential oscillation signal on two separate outputs OUT1 and OUT2. This arrangement is particularly advantageous, if the voltage controlled oscillator is implemented as an integrated circuit. The functions and characteristics of the voltage controlled oscillator of the second embodiment are the same as the functions and characteristics of the voltage controlled oscillator of the first embodiment explained above.

The voltage controlled oscillator of the second embodiment comprises a resonance circuit 31, a tuning circuit 32 to tune the resonance frequency of the tuning circuit 32 to the center frequency of the required frequency band, and a temperature detection circuit 33 for the temperature compensation of the tuned resonance frequency. The resonance circuit 1 comprises two transistors 34 and 35 operated respectively by an operating voltage V_{O}. The emitter of the transistor 34 is grounded via a resistor 39 and the emitter of the transistor 35 is grounded via a resistor 40. A capacitor 38 is connected between the base and the emitter of the transistor 35 and a transistor 36 is connected between the base and the emitter of the transistor 34. A further transistor 37 is connected in series between the resistor 36 and the resistor 38, whereby the emitter of the transistor 34 is connected to an intermediate point of the resistor 36 and the resistor 37 and the emitter of the transistor 35 ist connected to an intermediate point between the resistor 37 and the resistor 38.

The base of the transistor 34 is biased by a bias voltage V_{B} via a resistor 43 and coupled via a capacitor 42 to the first output terminal OUT1. The base of the transistor 35 is biased by a bias voltage V_{B} via a resistor 44 and coupled via a capacitor 41 to the second output terminal OUT2. The output oscillation signal is provided as a differential signal on the output terminals OUT1 and OUT2.

The tuning circuit 32 is coupled to the resonance circuit 31 via a capacitor 55 connected to the base of the transistor 34 and via a capacitor 54 connected to the base of the transistor 35. The resistors 54 and 55 are DC component cut off capacitors. The tuning circuit 32 includes a variable capacitance diode 45, which is grounded via a resistor 50 and tuned by a control voltage V_{C}. As for the variable capacitance diode 11, the capacitance of the variable capacitance diode 45 is defined by the DC voltage of the control voltage V_{C}. The control voltage V_{C} therefore sets the frequency of the resonance circuit 31.

An inductor 46 is connected in parallel to the variable capacitance diode 45 via two capacitors 48 and 49. The capacitors 48 and 49 serve as DC component cut off capacitors. The inductor 46 can be a discrete component, a dielectric pole or a strip line, for example. Another variable capacitance diode 47 is connected in parallel to the inductor 46 via a capacitor 51 and a capacitor 52. The variable capacitance diode 47 is grounded via the resistor 53. The capacitance of the variable capacitance diode 47 is tuned by an adjustment voltage from a D/A-converter 57 via a resistor 56. The adjustment voltage is thereby set by a control means 58, which is connected to a memory 59. The functions of the D/A-converter 57, the control means 58 and the memory 59 are identical to the functions of the D/A-converter 17, the control means 18 and the memory 19 of the first embodiment.

The temperature detection circuit 33 is operated by the same operating voltage V_{O} as the transistor 34 and includes a thermoresistor 61, which is grounded and connected in series to a resistor 60, which is connected to the operating voltage terminal. An A/D-converter 62 taps a temperature dependent voltage between the resistor 60 and the thermoresistor 61 and supplies this temperature information to the control means 58. The control means 58 reads temperature compensation information corresponding to the detected temperature from the memory 59 and causes the D/A-converter 57 to supply a corresponding adjustment voltage to the variable capacitance diode 47 to tune the resonance circuit 31 accurately to the set of frequency of the required frequency band. Therefore, the voltage controlled oscillator of the second embodiment, as the voltage controlled oscillator of the first embodiment, provides an accurate and stable oscillation signal even in varying temperature conditions.

## Claims

1. Voltage controlled oscillator, comprising
a resonance circuit (1, 31) to provide an oscillation signal, and
a tuning circuit (2, 32), which is connected to the resonance circuit and determines the frequency of the oscillation signal, whereby the tuning circuit (2, 32) includes electrically controlled adjustment means (13, 47) to tune the frequency of the oscillation signal,
**characterized by**
a temperature detection means (3, 33) for temperature compensation of the frequency of the oscillation signal.

2. Voltage controlled oscillator according to claim 1,
**characterized in,**
that the temperature detection means (3, 33) supplies a temperature detection signal to the tuning circuit (2, 32) for temperature compensation of the frequency of the oscillation signal.

3. Voltage controlled oscillator according to claim 2,
**characterized in,**
that the adjustment means (13, 47) is controlled on the basis of the temperature detection signal.

4. Voltage controlled oscillator according to claim 3,
**characterized in,**
that the adjustment means (13, 47) is controlled by a control means (18, 58) which temperature compensates the tuning of the frequency of the oscillation signal on the basis of the temperature detection signal.

5. Voltage controlled oscillator according to claim 4,
**characterized in,**
that the control means (18, 58) reads temperature compensation information corresponding to the received temperature detection signal from a memory means (19, 59) for the temperature compensation.

6. Voltage controlled oscillator according to one of the preceding claims,
**characterized in,**
that the temperature detection circuit (3, 33) comprises a thermal resistor (21, 61).

7. Voltage controlled oscillator according to one of the preceding claims,
**characterized in,**
that the temperature detection means (3, 33) and the resonance circuit (1, 31) are operated by the same operating voltage.
